# EUROPÄISCHE PATENTSCHRIFT

(11) **EP 2 976 816 B1**
(45) Veröffentlichungstag und Bekanntmachung des Hinweises auf die Patenterteilung: **13.05.2020**
(21) Anmeldenummer: 14723983.4
(22) Anmeldetag: 21.03.2014
(51) Int. Cl.: H01S 3/067, H01S 3/094, H01S 3/0941, G02B 19/00, H01S 5/40, G02B 27/09

(54) **LASERANORDNUNG**
LASER ASSEMBLY
ENSEMBLE LASER

(30) Priorität: 21.03.2013 DE 102013102891
(43) Veröffentlichungstag der Anmeldung: 27.01.2016
(73) Patentinhaber: Laserline Gesellschaft für Entwicklung und Vertrieb von Diodenlasern mbH, 56218 Mülheim-Kärlich (DE)
(72) Erfinder: KRAUSE, Volker, 56295 Lonning (DE); REHMANN, Georg, 56070 Koblenz (DE); BACHERT, Charley, 56060 Koblenz (DE)
(74) Vertreter: Glück Kritzenberger Patentanwälte PartGmbB
(86) Internationale Anmeldenummer: PCT/DE2014/100097
(87) Internationale Veröffentlichungsnummer: WO 2014/146649

(56) Entgegenhaltungen:
- WO-A1-2005/122345
- WO-A1-2010/007938
- DE-A1-102011 016 253
- US-A1- 2005 220 429
- US-A1- 2013 028 276

## Beschreibung

Die Erfindung bezieht sich auf eine Laseranordnung mit einem als Faserlaser ausgebildeten Konverter zur Erzeugung einer konvertierten Laser-Ausgangsstrahlung sowie mit einer eine Pumpstrahlung für den Konverter liefernden Pumpquelle mit mehreren die Pumpstrahlung erzeugenden Laserdioden.

Grundsätzlich bekannt sind Laseranordnungen, bei denen jeweils eine mit wenigstens einer Seltenerde dotierte, d.h. mit einem laseraktiven Material dotierte aktive Faser mit einer Pumpenstrahlung angeregt wird, so dass in dieser dotierten aktiven Faser zwischen zwei an den Faserenden vorgesehenen und als Resonatorspiegel wirkenden optischen Elementen eine Laserstrahlung mit einer Strahlungsemission an einem Faserende erzwungen wird. Bekannt ist hierbei auch, die aktive Faser mit einem dicht dotierten Mantel aus einem Licht leitenden Material, nämlich aus Glas oder Quarzglas zu umgeben, der dann einen Pumpmantel bildet, welcher mit der Pumpstrahlung beaufschlagt wird und über den die Strahlung in der aktiven Faser bzw. in dem dotierten Kern der von der aktiven Faser und dem Pumpmantel gebildeten Konverterfaser stimuliert wird. Bekannt ist weiterhin die Faserenden, d.h. die Anschlüsse oder Einkopplungen von Konverterfasern mit einem flüssigen Kühlmedium (US 4 732 450) oder aber die Konverterfaser mit einem entlang dieser Faser strömenden Kühlmedium zu kühlen (RU 2031 420, US 2005/0220429 A1). Aus US 2013/0028276 A1 ist bekannt, den Faseranschluss mittels eines ihn durchströmenden Kühlmediums zu kühlen und die Konverterfaser auf einer gekühlten Spule aufzuwickeln.

Bekannt sind schließlich Diodenlaseranordnungen (DE 10 2011 016 253), die generell aus einer Laserlicht aussendenden Quelle in Form wenigstens eines Laserdiodenstapels aus mehreren jeweils an einem Kühler vorgesehenen Laserbarren, die jeweils eine Vielzahl von Laserlicht aussendenden und in einer Slow-Axis aufeinander folgende Emitter aufweisen, sowie aus einer Plattenfächer aufweisenden Strahlformoptik bestehen.

Aufgabe der Erfindung ist es, eine Laseranordnung aufzuzeigen, der eine Laserstrahlung hoher Qualität bereitstellt. Zur Lösung dieser Aufgabe ist eine Laseranordnung entsprechend dem Patentanspruch 1 ausgebildet.

Die erfindungsgemäße Laseranordnung ist für einen Leistungsbereich der konvertierten Laserstrahlung von wenigen kW bis hin zu Leistungen größer 10 kW realisierbar. Weiterhin ist die erfindungsgemäße Laseranordnung für unterschiedliche Bereiche nutzbar, d.h. z.B. in der Medizin, aber auch bei der Ver- und/oder Bearbeitung von Werkstücken, beispielsweise zum hochqualitativen Schneiden von Werkstücken und/oder Blechen, zum Erhitzen von Werkstücken beispielsweise zum Härten usw. Die als Pumpquelle dienende Diodenlaseranordnung ist beispielsweise so ausgeführt, dass die Wellenlänge der Pump-Laser-Strahlung im Bereich zwischen 900 nm und 1050 nm liegt, wobei dann die Wellenlänge der von der Laseranordnung bzw. von dessen Konverter abgegebenen konvertierten Laserstrahlung höher liegt, beispielsweise im Bereich zwischen 1050 nm und 1100 nm.

Bei einer bevorzugten Ausführungsform ist der Pumpmantel der Konverterfaser von wenigstens einem weiteren Mantel, beispielsweise aus einem feuchtigkeits- und/oder wasserfesten Kunststoff umgeben, wobei dieser Mantel dann bei einer besonders vorteilhaften Ausführungsform von einem weiteren äußeren Mantel aus einem korrosionsbeständigen metallischen Material umschlossen ist. Durch den den Pumpmantel umgebenden weiteren Mantel wird u.a. erreicht, dass die Pumpstrahlung durch Totalreflexion innerhalb des Pumpmantels verbleibt und diese somit intensiv auf die innere, aktive Faser einwirkt.

Erfindungsgemäß ist die Konverterfaser in einer rohr- und/oder schlauchartigen Umhüllung untergebracht, welches von einem Kühlmedium, vorzugsweise von einem flüssigen Kühlmedium durchströmt wird. Die Einkopplungen und Auskopplungen für die Laserstrahlung in bzw. aus der Konverterfaser bzw. entsprechende aus Licht durchlässigen Material, vorzugsweise aus Glas oder Quarzglas hergestellte Anschlüsse oder Endkappen reichen dabei ebenfalls jeweils zumindest mit einem Teilbereich in das Innere des Kühlgehäuses und werden somit ebenfalls mit dem Kühlmedium gekühlt.

"Aktive Schicht" des Laserbarrens ist dabei die Schicht in der die Emitter des Laserbarrens angeordnet sind und deren Ebene senkrecht zu der Fast-Achse orientiert ist, in der die Laserstrahlen der Emitter die größere Divergenz aufweisen.

Der Ausdruck "im Wesentlichen" bzw. "etwa" bedeutet im Sinne der Erfindung Abweichungen vom jeweils exakten Wert um +/- 10%, bevorzugt um +/- 5% und/oder Abweichungen in Form von für die Funktion unbedeutenden Änderungen.

Weiterbildungen, Vorteile und Anwendungsmöglichkeiten der Erfindung ergeben sich auch aus der nachfolgenden Beschreibung von Ausführungsbeispielen und aus den Figuren.

Die Erfindung wird im Folgenden anhand der Figuren an Ausführungsbeispielen näher erläutert. Es zeigen:
- Fig. 1: in vereinfachter Darstellung eine Laseranordnung mit aktiv gekühlter Konverterfaser gemäß der Erfindung;
- Fig. 2, 3: in schematischer Darstellung eine von einer Diodenlaseranordnung gebildete Pumpquelle der Laseranordnung der Figur 1;
- Fig. 4: in vereinfachter Darstellung die Ausbildung des Laserstrahlen zweier Laserbarren vor dem Umformen, nach dem Auffächern und nach dem Zusammenführen;
- Fig. 5, 6: Querschnitte der Konverterfaser bei unterschiedlichen Ausführungsformen;
- Fig. 7: in vergrößerter schematischer Darstellung und im Schnitt die gekühlte Konverterfaser der Laseranordnung der Figur 1;
- Fig. 8: einen Schnitt entsprechend der Linie I - I der Figur 6;
- Fig. 9: in einer Darstellung ähnlich Figur 1 eine weitere Ausführungsform der erfindungsgemäßen Laseranordnung.

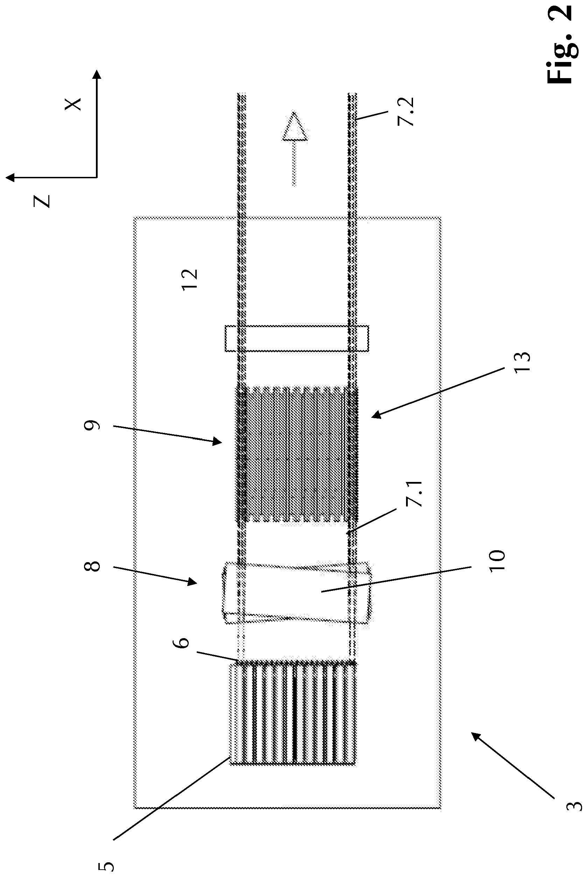

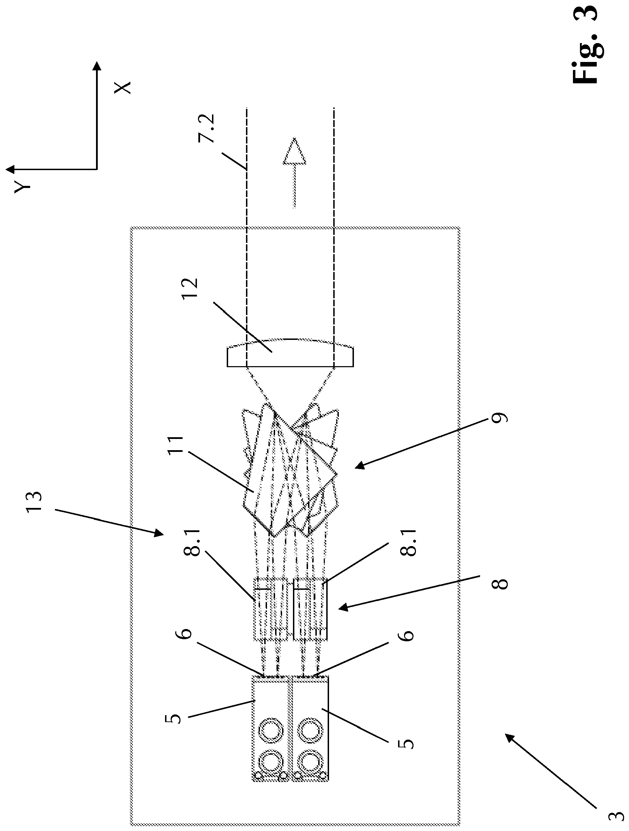

Zur Vereinfachung des Verständnisses sind in den Figuren 2 und 3 jeweils mit X, Y und Z drei senkrecht zueinander orientierte Raumachsen bezeichnet.

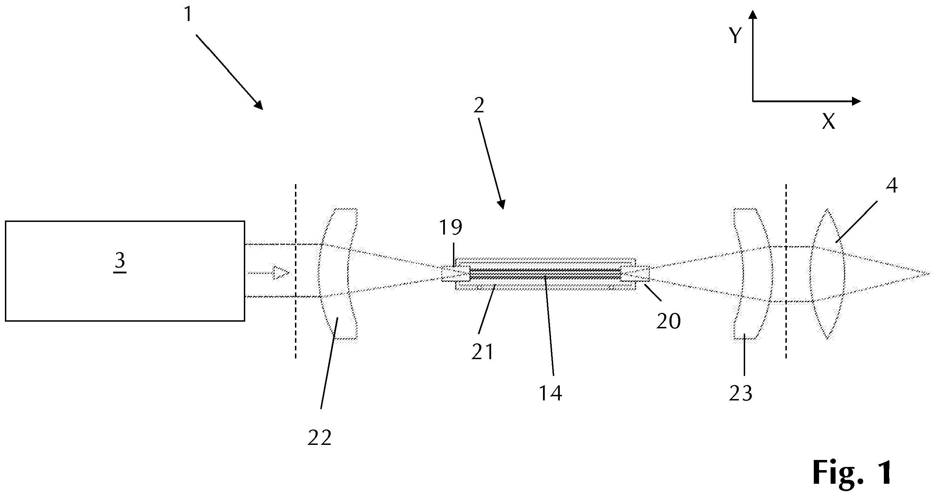

Die in den Figuren 1 - 8 allgemein mit 1 bezeichnete Laseranordnung besteht im Wesentlichen aus einem Konverter 2 in Form eines Faserlasers, aus einer als Pumpquelle für den Konverter 2 dienenden Diodenlaseranordnung 3 und aus einer Fokussieroptik für die aus dem Konverter 2 ausgekoppelte konvertierte Laserstrahlung. Die vorgenannten Komponenten weisen bei der dargestellten Ausführungsform den nachstehend beschriebenen Aufbau auf:

### Diodenlaseranordnung 3

Die Diodenlaseranordnung 3 besteht bei der dargestellten Ausführungsform aus zwei parallelen und in Richtung der Y-Achse gegeneinander versetzten Laserdioden-Stapeln 5, die jeweils eine Vielzahl von in Richtung der Z-Achse stapelartig übereinander angeordneten Laserbarren 6 aufweisen, die jeweils an einem Kühlkörper vorgesehen und eine Vielzahl von Laserlicht aussendenden Emittern aufweisen. Letztere sind in Richtung ihrer Slow-Achse (Y-Achse) und damit senkrecht zur Stapelachse bzw. Z-Achse an dem jeweiligen Laserbarren 6 aufeinander folgend vorgesehen und senden das Laserlicht in Richtung der X-Achse aus, die senkrecht zur Slow-Achse und Fast-Achse der Emitter orientiert und bei der dargestellten Ausführungsform die optische Achse der Diodenlaseranordnung 3 ist. Weiterhin ist die Anordnung so getroffen, dass jeder Laserbarren 6 eines Stapels 5 niveaugleich mit dem Laserbarren 6 des anderen Stapels 5 liegt.

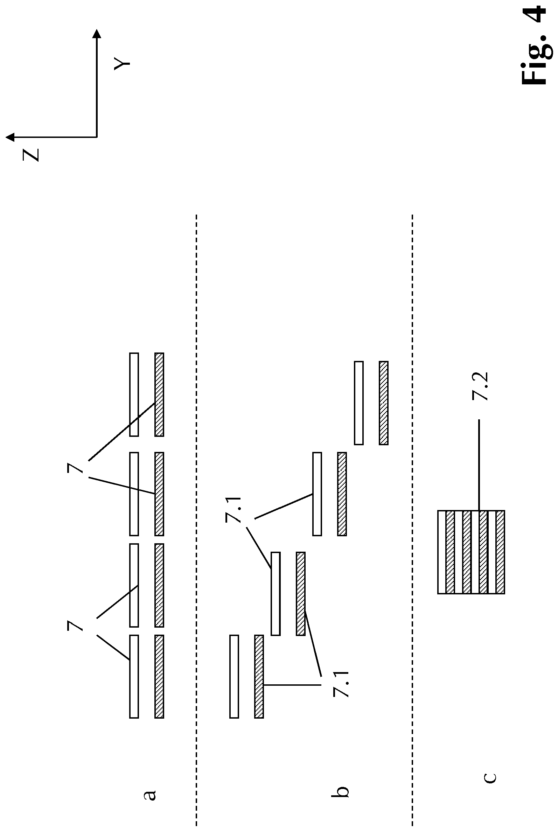

Im Strahlengang der von den Laserbarren 6 ausgesendeten Laserstrahlung in Form eines Strahlenbündels aus Einzelstrahlen 7 befindet sich ein in den Figuren 2 und 3 nicht dargestellter Fast-Axis-Kollimator, der beispielsweise von einer mit ihrer Achse in der Y-Achse liegenden Zylinderlinse gebildet ist und eine Kollimation der Laserstrahlen bzw. der Einzelstrahlen 7 in der Fast-Achse, d.h. in der Z-Achse senkrecht zu der aktiven Schicht der Laserbarren 6 bewirkt, in der (Fast-Achse) die Strahlung der Emitter jedes Laserbarren 6 die größte Divergenz aufweist. Nach dem Fast-Axis-Kollimator besteht die Laserstrahlung im Wesentlichen als schmalbandiges Strahlenbündel aus Einzelstrahlen 7, wie dies in der Figur 4 in der Position a) dargestellt ist. Auf den Fast-Axis-Kollimator folgt im Strahlengang eine optische Einrichtung 8, die als Plattenfächer ausgebildet ist und zur weiteren Formung des Laserstrahlbündels dient, und zwar in der Weise, dass das Laserstrahlbündel zunächst in Strahlen 7.1 in verschiedenen Ebenen parallel zu der XY-Ebene zertrennt bzw. aufgefächert wird, wobei die Strahlen 7.1 von Ebene zu Ebene auch in der Y-Achse gegeneinander versetzt sind, wie dies in der Figur 4 in der Position b) dargestellt ist. In einer weiteren, ebenfalls als Plattenfächer ausgebildeten optischen Einrichtung 9 werden die Einzelstrahlen 7.1 auch mehrerer Laserbarren 6 dann in der in der Figur 4 in der Position c) dargestellten Weise diagonal übereinander geschoben, sodass sich ein Strahlenbündel 7.2 ergibt. In der Figur 4 sind die Laserstrahlen 7, 7.1 und 7.2 von zwei Laserbarren 6 eines Stapels 5 wiedergegeben. Zur besseren Unterscheidung sind die Laserstrahlen eines Laserbarrens 6 schraffiert und die des andren Laserbarrens 6 nicht schraffiert.

Im Detail besteht die optische Anordnung 8 aus zwei parallelen Plattenfächern 8.1, die bei der dargestellten Ausführungsform grundsätzlich identisch ausgebildet sind und jeweils aus mehreren dünnen Platten 10 bestehen. Diese sind aus einem Licht leitenden Material, beispielsweise aus Glas (optisches Glas) oder Quarzglas hergestellt und weise z.B. einen quadratischen Zuschnitt auf. Jede mit ihren Oberflächenseiten in der XZ-Ebene angeordnete Platte besitzt zwei einander gegenüberliegende Plattenschmalseiten für den Eintritt und den Austritt der Laserstrahlen. Diese Stirnseiten sind gegenüber der optischen Achse bzw. X-Achse von Platte zu Platte unterschiedlich geneigt, sodass sich eine Fächerartige Struktur ergibt und die Auffächerung der Einzelstrahlen 7 in die Einzelstrahlen 7.1 in Richtung der Z-Achse erfolgt.

Die optische Einrichtung 9 besteht ebenfalls aus einer Vielzahl von stapelartig an einander anschließenden Platten 11 aus dem Licht leitenden Material bzw. Glas oder Quarzglas. Die Platten 11 sind mit ihren Oberflächenseiten in der XY-Ebene angeordnet und weisen wiederum im Strahlweg der Laserstrahlen jeweils zwei parallele plane Stirnseiten für den Eintritt und Austritt der Laserstrahlen auf. Diese Stirnseiten sind gegenüber der optischen Achse (X-Achse) von Platte zu Platte unterschiedlich geneigt, so dass sich eine Fächerartige Struktur ergibt und das Übereinanderschieben der Einzelstrahlen 7.1 zu dem Strahlenbündel 7.2 erfolgt, wie dies in der Figur 4 in der Position c) dargestellt ist.

Auf die optische Einrichtung 9 folgend ist ein Slow-Axis-Kollimator 12 vorgesehen, der die Divergenz, die die Laserstrahlen in der Slow-Axis (Y-Achse) aufweisen, korrigiert und bei der dargestellten Ausführungsform von einer Zylinder-Linse gebildet ist, die lediglich um eine Achse parallel zur Y-Achse gekrümmt ist.

Der nicht dargestellte Fast-Axis-Kollimator, die optischen Einrichtungen 8 und 9 sowie der Slow-Axis-Kollimator 12 bilden bei der dargestellten Ausführungsform die Strahlformoptik 13 der Diodenlaseranordnung 3.

### Konverter 2

Der als Faserlaser ausgebildete Konverter 2 umfasst u.a. eine Konverterfaser 14, die bei der dargestellten Ausführungsform mehrschichtig, d.h. mit einer inneren aktiven Faser 15 (aktiver Kern) aus einem Licht leitenden Material, bevorzugt aus Glas oder Quarzglas. Die Faser 15 ist zumindest mit einem laseraktiven Medium oder Stoff, beispielsweise mit Erbium und/oder Ytterbium und/oder Neodym dotiert, und von einem Mantel 16 aus einem Licht leitenden Material, vorzugsweise aus Glas oder Quarzglas umgeben, der den Pumpmantel (Pumpclad) der Konverterfaser 14 bildet und aus undotierten Licht leitenden Material, vorzugsweise Glas oder Quarzglas besteht. Der Mantel 16 ist umgeben von einem weiteren Mantel 17 aus einem geeigneten Kunststoff, beispielsweise wasserbeständigen Kunststoff. Als äußerer Abschluss der Konverterfaser 14 dient ein äußerer Mantel 18 beispielsweise aus einem korrosionsfesten metallischen Material.

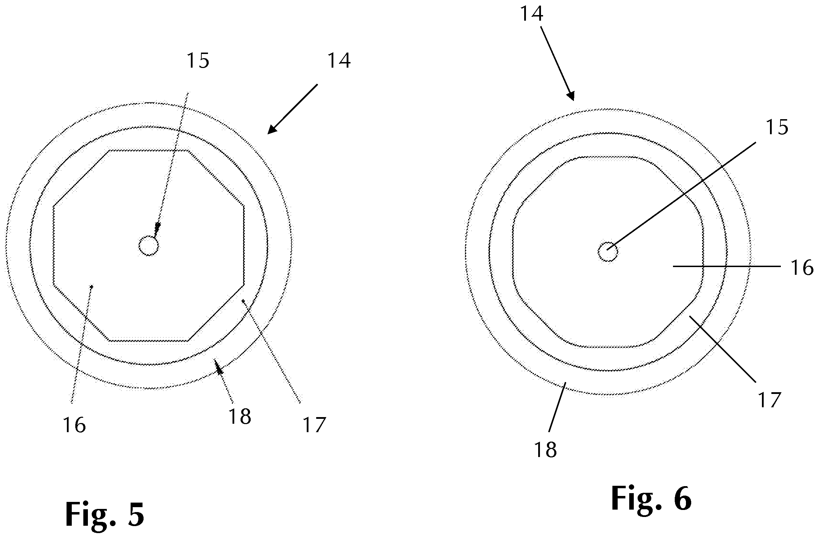

In den Figuren 5 und 6 ist dieser Aufbau der Konverterfaser 14 dargestellt. Wie diesen Figuren auch zu entnehmen, weist der als Pumpmantel dienende Mantel 16 einen von der Kreisform abweichenden Querschnitt auf, um so das Einkoppeln der von der Pumpquelle bzw. von der Diodenlaseranordnung 3 gelieferten Laser- oder Pumpstrahlung in die innere aktive Faser 15 zu optimieren. In der Figur 5 besitzt der Mantel 16 einen achteckigen Querschnitt mit ausgeprägten Ecken und in der Figur 6 einen achteckigen Querschnitt mit abgerundeten Ecken. Die innere Faser 15 besitzt beispielsweise einen Durchmesser im Bereich zwischen 10 *µ*m und 20 *µ*m und der Mantel 16 einen Durchmesser von etwa 400 *µ*m bis 200 *µ*m. Auch andere hierfür geeignete Querschnitte der Konverterfaser 14 sind möglich, beispielsweise eine exzentrische Anordnung der aktiven Faser 15 im Mantel 16, der auch in diesem Fall dann bevorzugt einen von der Kreisform abweichenden Querschnitt aufweist.

An ihren beiden Enden ist die Konverterfaser 14 jeweils mit einem den Eintritt und Austritt von Laserstrahlung in die Konverterfaser 14 bzw. aus dieser Faser ermöglichenden optischen Anschluss in Form einer Endkappe 19 und 20 aus Licht leitendem Material, bevorzugt aus Glas oder Quarzglas versehen. Weiterhin ist die Konverterfaser 14 im Innenraum 21.3 einer sich über die gesamte Länge dieser Faser erstreckenden und von einem Kühlmedium, beispielsweise von einem flüssigen Kühlmedium oder von Kühlwasser durchströmbaren Umhüllung 21 untergebracht, an deren Enden auch die Endkappen 19 und 20 vorgesehen sind, die zu ihrer Kühlung jeweils mit einer Teillänge in die Umhüllung 21 bzw. in deren Innenraum 21.3 hineinreichen. Die Konverterfaser 14 ist vollständig in der Umhüllung 21 aufgenommen.

Erfindungsgemäß ist die Umhüllung 21 rohr- oder schlauchartig ausgebildet, und zwar mit einem Kühlmediumeinlass 21.1 im Bereich der u.a. mit der Laserstrahlung aus dem Diodenlaser 3 beaufschlagten Endkappe 19 und mit einem Kühlmediumauslass 21.2 im Bereich der Endkappe 20, die u.a. auch zum Ausleiten der mit dem Konverter 2 konvertierten Laserstrahlung dient. Die beiden Endkappen 19 und 20 sind mit einer Antireflexionsschicht für die Pumpstrahlung und die konvertierte Laserstrahlung vergütet und beispielweise mittels einer Spleißverbindung auch mit der aktiven Faser 15 verbunden. Weiterhin verfügen die Endkappen 19 und 20 beispielsweise über eine Länge von 10 mm bis 40 mm und über einen Durchmesser im Bereich zwischen etwa 5 mm und 20 mm.

Der Konverter 2 umfasst weiterhin zwei Resonatorspiegel 22 und 23, von denen der Resonatorspiegel 22 u.a. im Strahlengang des von der Diodenlaseranordnung 3 gelieferten Laserstrahlung liegt und eine Fokussierung dieser Strahlung auf die Endkappe 19 bzw. auf die Konverterfaser 14 bewirkt und hierfür an seiner der Endkappe 19 abgewandten Seite konvexlinsenartig gekrümmt ist. An der der Endkappe 19 zugewandten Seite ist der Resonatorspiegel 22 für seine Resonatorspiegelfunktion hohlspiegelartig konvex gekrümmt. Weiterhin ist der Resonatorspiegel 22 so ausgebildet, dass er an seiner der Endkappe 19 abgewandten Einkoppelseite keine oder im Wesentlichen keine Reflexionseigenschaften aufweist, d.h. als Antireflexionsspiegel für die Pumpstrahlung ausgebildet ist und an seiner der Endkappe 19 zugewandten Seite eine hohe Reflexion besitzt, d.h. als Hochreflexionsspiegel für die aus der Konverterfaser 14 austretenden Strahlung ausgebildet ist. Die Resonatorspiegel 22 und 23 sind bevorzugt justierbar ausgeführt.

Ein weiterer Resonatorspiegel 23 ist im Strahlengang auf die Endkappe 20 folgend vorgesehen. Dieser Resonatorspiegel 23 ist wiederum an seiner der Endkappe 20 abgewandten Seite zur Erzeugung einer parallelen oder im Wesentlichen parallelen Ausgangs-Laserstrahlung konvex bzw. konvex-linsenartig und an seiner der Endkappe 20 zugewandten Seite hohlspiegelartig konkav gekrümmt. Weiterhin ist der Resonatorspiegel 23 so ausgeführt, dass er an seiner konkaven Seite als Hochreflexionsspiegel für die Pumpstrahlung und als Antireflexionsspiegel für die konvertierte Ausgangsstrahlung des Konverters wirkt, d.h. einen Durchtritt der konvertierten Ausgangsstrahlung oder Laserstrahlung ohne Reflexion oder im Wesentlichen ohne Reflexion ermöglicht.

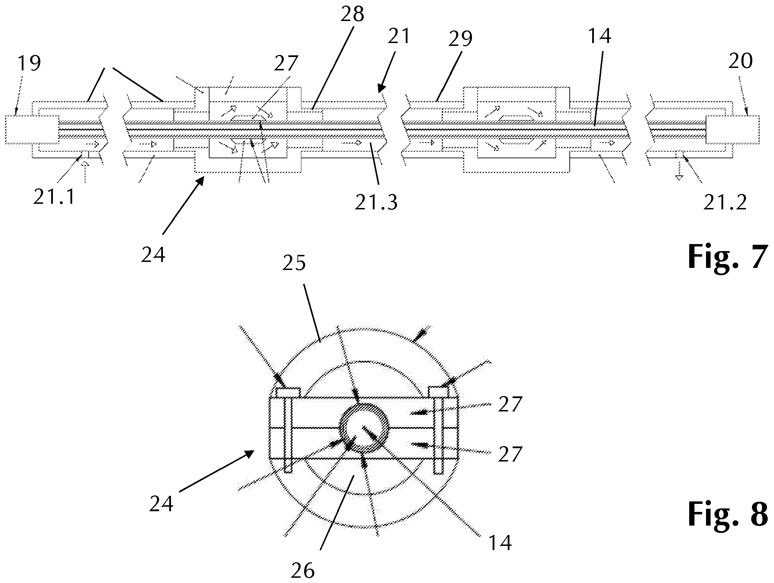

Figuren 7 und 8 zeigen nochmals in vergrößerter Darstellung die Konverterfaser 14 mit der Umhüllung 21 und mit dem von dieser gebildeten, die Konverterfaser 14 auf ihren gesamten Umfang umschließenden ringförmigen Kühlkanal 21.3. Um sicher zu stellen, dass die Konverterfaser 14 über ihre gesamte Länge stets von der Innenfläche der Umhüllung 21 beabstandet ist und somit der Kühlkanal 21.3 über die gesamte Länge der Konverterfaser 14 optimal ausgebildet ist, ist die Konverterfaser 14 mehrfach durch jeweils ein Abstützelement 24 gehalten. Dieser besteht im Wesentlichen aus einem Gehäuse 25, welches einen nach außen hin geschlossenen Gehäuseinnenraum 26 bildet, in dem die durch den Gehäuseinnenraum 26 hindurch geführte Konverterfaser 14 zwischen einem oberen und einem unteren Faserhalter 27 gehalten ist. An zwei einander gegenüberliegenden Seiten des Gehäuses 25 ist jeweils ein flanschartiger Anschluss 28 vorgesehen, durch den die Konverterfaser 14 hindurchgeführt ist und welcher zum Anschluss eines Schlauch- oder Rohrstückes 29 dient, das Teil der Umhüllung 21 ist. Diese besteht somit bei der dargestellten Ausführungsform aus den Halteelementen 24 und den Schlauch- oder Rohrstücken 29.

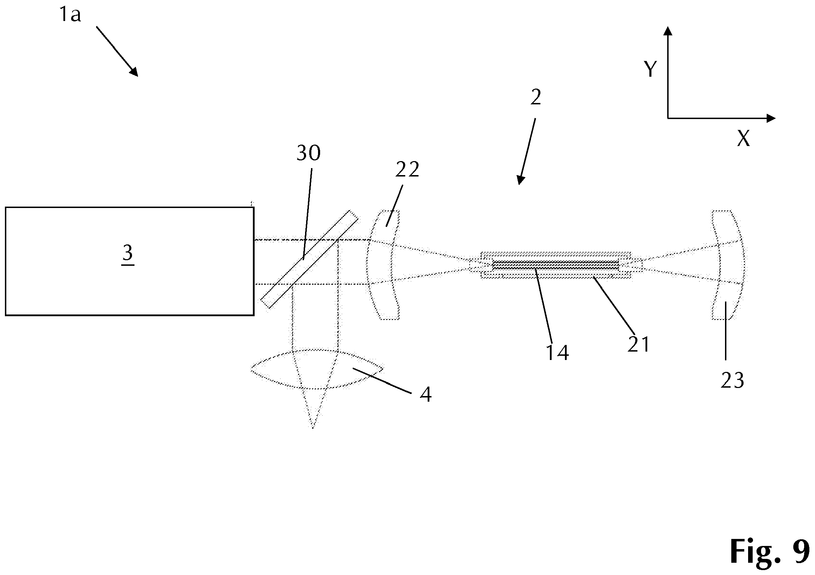

Die Figur 9 zeigt als weitere Ausführungsform einer Laseranordnung 1a, der sich von der Laseranordnung 1 dadurch unterscheidet, dass die konvertierte Laserstrahlung nicht an dem Resonatorspiegel 23, sondern zwischen der Pumpquelle bzw. Diodenlaseranordnung 3 und dem Resonatorspiegel 22, d.h. an diesem Resonatorspiegel ausgekoppelt wird, und zwar über einen dichroitischer Spiegel 30, der gegenüber der Achsrichtung der Pumpstrahlung der Diodenlaseranordnung 3, d.h. gegenüber der X-Achse geneigt ist und dessen Oberflächenseiten mit der Y-Z-Ebene einen Winkel kleiner als 90°, beispielsweise einen Winkel 45° oder im Wesentlichen von 45° einschließen. Der Spiegel 30 trennt die Laserstrahlung der Diodenlaseranordnung 3 von der konvertierten Laserstrahlung der Konverterfaser 14. Mögliche Kombinationen der Eigenschaften des Spiegels 30 sind hierbei:
- Der Spiegel 30 ist für die Pumpstrahlung durchgängig, für die konvertierte Strahlung aber hoch reflektierend, oder aber
- der Spiegel 30 ist hoch reflektierend für die Pumpstrahlung, für die konvertierte Strahlung aber durchgängig.

Die Wellenlänge der von der Diodenlaseranordnung 3 gelieferten Laserstrahlung liegt beispielsweise im Bereich zwischen 900 nm und 1500 nm. Die Wellenlänge der konvertierten Laserstrahlung liegt oberhalb der Wellenlänge der Pumpstrahlung, beispielsweise bei 1500 nm bis 1100 nm. Die von der Diodenlaseranordnung 3 gelieferte Pumpstrahlung liegt beispielsweise in einem Leistungsbereich von einigen kW bis hin zu Leistungen größer 10 kW. Auch aus diesem Grund ist eine optimale Kühlung der Konverterfaser 14 zur Abführung von Verlustleistungen notwendig, die u.a. beim Einkoppeln der Pumpstrahlung in die innere Faser 15 entsteht.

Zur Erhöhung der Pumpleistung und damit auch der Ausgangsleistung und/oder der Leistungsdichte ist es zweckmäßig die Diodenlaseranordnung 3 so zu betreiben, dass die Pumpstrahlung ein Wellenlängenmultiplexing von mehreren Wellenlängen aus einem Wellenlängenbereich der Pumpstrahlung aufweist, beispielsweise aus dem Wellenlängenbereich zwischen 900 nm und 1060 nm.

Die Erfindung wurde voranstehend an Ausführungsbeispielen beschrieben. Es versteht sich, dass zahlreiche Änderungen sowie Abwandlungen möglich sind, ohne dass dadurch der der Erfindung zugrundeliegende Erfindungsgedanke verlassen wird. Die Erfindung ist in den Ansprüchen definiert.

### Bezugszeichenliste

- 1, 1a: Laseranordnung
- 2: Konverter
- 3: Diodenlaseranordnung (Pumpquelle)
- 4: Fokussieroptik
- 5: Stapel
- 6: Laserbarren
- 7, 7.1, 7.2: Einzelstrahlen
- 8, 9: optisches Element
- 8.1: Plattenfächer
- 10, 11: Platten
- 12: Slow-Axis-Kollimator
- 13: Strahlformoptik
- 14: Konverterfaser
- 15: innere aktive Faser oder aktiver Kern
- 16 - 18: Mantel
- 19, 20: Endkappe
- 21: Umhüllung
- 21.1, 21.2: Anschluss
- 21.3: Kühlkanal
- 22, 23: Resonatorspiegel
- 24: Halteeinrichtung
- 25: Gehäuse
- 26: Gehäuseinnenraum
- 27: Faserhalter
- 28: Anschluss
- 29: Rohr- oder Schlauchstück
- 30: Spiegel
- X, Y, Z: Raumachsen

## Patentansprüche

1. Laseranordnung mit einem als Faserlaser ausgebildeten Konverter (2) zur Erzeugung einer konvertierten Laser-Ausgangsstrahlung sowie mit einer eine Pumpstrahlung für den Konverter (2) liefernden Pumpquelle (3) mit mehreren die Pumpstrahlung erzeugenden Laserdioden, die jeweils von Emittern an Laserbarren (6) gebildet sind, wobei die Pumpquelle (3) eine Strahlformoptik (13) zur Formung der von den Emittern gelieferten Laserstrahlen (7) in die Pumpstrahlung aufweist, in der Pumpquelle (3) wenigstens zwei Laserbarren (6), deren Emitter in einer ersten einer Slow-Achse entsprechenden Achsrichtung (Y-Achse) aufeinander folgend vorgesehen und die mit ihren aktiven Schichten jeweils in einer Ebene (XY-Ebene) angeordnet sind, welche die erste Achse (Y-Achse) sowie eine hierzu senkrechte zweite Achse (X-Achse) einschließt, in einer dritten einer Fast-Achse entsprechenden Achse (Z-Achse), die senkrecht zur ersten und zweiten Achse orientiert ist, in wenigstens einem Diodenlaserstapel (5) übereinander angeordnet sind, und die Strahlformoptik (13) im Strahlengang auf den Diodenlaserstapel (5) folgend eine erste optische Einrichtung zum Auffächern der von den Emittern jedes Laserbarrens (6) gelieferten Laserstrahlen (7) in der dritten Achse sowie an die erste optische Einrichtung anschließend eine zweite optische Einrichtung (9) aufweist, mit der die aufgefächerten Laserstrahlen (7.1) sämtlicher Laserbarren (6) durch Übereinanderschieben in Richtung der ersten Achse (Y-Achse) zu einem Laserstrahlbündel (7.2) zusammengeführt werden,
wobei der Konverter (2) eine mehrschichtige Konverterfaser (14) mit einer inneren aktiven Faser (15) aus einem Licht leitenden und mit einem laseraktiven Medium oder Stoff dotierten Material umfasst, die im Innenraum (21.3) einer sich über die gesamte Länge der Faser erstreckenden, rohrförmigen oder schlauchartigen und von einem flüssigen Kühlmedium durchströmbaren Umhüllung (21) aufgenommen ist, wobei die Konverterfaser (14) an ihren beiden Enden jeweils mit einer aus einem Licht leitenden Material bestehenden Anschluss in Form einer Endkappe (19, 20) zum Einkoppeln und/oder Auskoppeln der Pumpstrahlung und der konvertierten Strahlung versehen ist, die zu ihrer Kühlung jeweils mit einer Teillänge in den Innenraum (21.3) der Umhüllung (21) hineinreichen und die mit einer Antireflexionsschicht für die Pumpstrahlung und die konvertierte Strahlung vergütet und mittels einer Spleißverbindung mit der aktiven Faser (15) verbunden sind.

2. Laseranordnung nach Anspruch 1, **dadurch gekennzeichnet, dass** die erste und zweite optische Einrichtung (8, 9) jeweils von wenigstens einem Plattenfächer (8.1, 9) mit mehreren an ihren Oberflächenseiten aneinander anschließenden Platten (10, 11) gebildet sind, dass die Platten (10) der ersten optischen Einrichtung (8) mit ihren Oberflächenseiten senkrecht zur ersten Achse (Y-Achse) und die Platten (11) der zweiten optischen Einrichtung (9) mit ihren Oberflächenseiten senkrecht zur dritten Achse (Z-Achse) orientiert sind.

3. Laseranordnung nach Anspruch 1 oder 2, **dadurch gekennzeichnet, dass** wenigstens zwei parallele und in Richtung der ersten Achse (Y-Achse) gegen einander versetzte Diodenlaserstapel (5) vorgesehen sind, dass die Laserbarren (6) eines Diodenlaserstapels mit ihren aktiven Schichten parallel zu den aktiven Schichten der Laserbarren (6) des anderen Stapels orientiert sind.

4. Laseranordnung nach einem der vorhergehenden Ansprüche, **dadurch gekennzeichnet, dass** der Konverter (2) eine von einem Kühlmedium umströmte Konverterfaser (14) aufweist, die wenigstens aus einer inneren mit einem laseraktiven Zusatz dotierte Faser (15) aus Licht leitendem Material, vorzugsweise aus Glas oder Quarzglas, sowie aus einem diese innere Faser (15) umgebenden nicht dotierten Pumpmantel (16) aus einem Licht leitenden Material, vorzugsweise aus Glas oder Quarzglas besteht.

5. Laseranordnung nach einem der vorhergehenden Ansprüche, **dadurch gekennzeichnet, dass** an den Enden der Konverterfaser (14) oder diesen Enden gegenüberliegend jeweils ein als Resonatorspiegel wirkendes optisches Element (22, 23) vorgesehen ist, und dass das eine im Strahlengang zwischen der Pumpquelle (3) und der Konverterfaser (14) angeordnete und von der Pumpstrahlung der Pumpquelle durchströmte optische Element (22) für die von der Pumpquelle in die Konverterfaser (14) eingekoppelte Laser- oder Pumpstrahlung als Antireflexionsspiegel und für die von der Konverterfaser (14) kommende Strahlung als Spiegel mit hoher Reflexion wirkt.

6. Laseranordnung nach Anspruch 5, **dadurch gekennzeichnet, dass** beim Auskoppeln der konvertierten Strahlung an dem zweiten, als Resonatorspiegel wirkenden optischen Element (23) dieses Element als Spiegel hoher Reflexion für die Pumpstrahlung und als Antireflexionsspiegel für die aus der Konverterfaser (14) ausgekoppelte konvertierte Strahlung wirkt.

7. Laseranordnung nach Anspruch 5 oder 6, **dadurch gekennzeichnet, dass** die optischen Elemente jeweils Konkav-Konvex-Resonatorspiegel (22, 23) sind, die an ihrer den Enden der Konverterfaser (14) zugewandten Seite jeweils hohlspiegelartig konkav und an ihrer der Konverterfaser (14) abgewandten Seite jeweils sammellinsenartig konvex gewölbt sind.

8. Laseranordnung nach einem der Ansprüche 5 - 7, **dadurch gekennzeichnet, dass** die optischen Elemente (22, 23) aus einem lichtdurchlässigen Material, vorzugsweise Glas oder Quarzglas bestehen, und dass die Reflexionseigenschaften durch Materialeigenschaften und/oder eine Oberflächenbeschichtung erreicht sind.

9. Laseranordnung nach einem der vorhergehenden Ansprüche, **dadurch gekennzeichnet, dass** die Wellenlänge der Pumpstrahlung im Bereich zwischen 900nm und 1050nm und/oder die Wellenlänge der konvertierten Strahlung im Bereich von 1050nm und 1100nm liegt.

10. Laseranordnung nach einem der vorhergehenden Ansprüche, **dadurch gekennzeichnet, dass** die Umhüllung (21) aus zwei, über wenigstens ein Halteelement (24) für die Konverterfaser (14) miteinander verbundenen Rohr- und/oder Schlauchstücken (29) besteht.

11. Laseranordnung nach einem der vorhergehenden Ansprüche, **dadurch gekennzeichnet, dass** die innere, aktive Faser ein Durchmesser im Bereich zwischen 10 *µ*m und 200 *µ*m und/oder der Pumpmantel (16) einen Durchmesser im Bereich zwischen 400 *µ*m und 2000 *µ*m aufweist.

12. Laseranordnung nach einem der Ansprüche 1 - 5, **dadurch gekennzeichnet, dass** bei einer Auskopplung des konvertierten Laserstrahls an der der Pumpquelle (3) zugewandten Seite des Konverters (2) im Strahlengang des Pumpstrahls ein Spiegel (30) angeordnet ist, der die Strahlung von der Pumpquelle an den Konverter von eine Strahlung in umgekehrter Richtung trennt.

## Claims

1. Laser assembly comprising a converter (2) designed as a fiber laser for generating a converted laser output radiation, and comprising a pump source (3) supplying a pump radiation for the converter (2), said pump source comprising multiple laser diodes generating the pump radiation which are each formed by emitters on laser bars (6),
wherein the pump source (3) has a beam shaping optics (13) for shaping the laser beams (7) supplied by the emitters into the pump radiation, at least two laser bars (6) are arranged in the pump source (3) above one another in at least one diode laser stack (5) in a third axis (Z axis) corresponding to a fast axis, which is oriented perpendicular to a first and second axes, the emitters of said laser bars being provided one following the other in the first axis direction (Y axis) corresponding to a slow axis and which are arranged with their active layers in a respective plane (XY plane) which includes the first axis (Y axis) and the second axis (X axis) perpendicular thereto, and, in the beam path following the diode laser stack (5), the beam shaping optics (13) has a first optical device for fanning out the laser beams (7) in the third axis which are supplied by the emitters of each laser bar (6), and a second optical device (9), adjacent to the first optical device and with which the fanned out laser beams (7.1) from all laser bars (6) are combined through superimposition in the direction of the first axis (Y axis) into a laser beam bundle (7.2),
wherein the converter (2) comprises a multi-layer converter fiber (14) with an inner active fiber (15) made from a light conducting material and doped with a laser active medium or material, which is accommodated in the interior (21.3) of a tubular or hose-like sheath (21) which extends across the entire length of the fiber and can be flowed through by a liquid cooling medium,
wherein the converter fiber (14) is provided on each of its two ends with a connection, consisting of a light-conducting material, in the shape of an end cap (19, 20) for coupling in and/or coupling out the pump radiation and the converted radiation, said end caps each extend with a partial length into the interior (21.3) of the sheath (21) for their cooling, and are annealed with an antireflection coating for the pump radiation and the converted radiation, and are connected to the active fiber (15) by means of a splice connection.

2. Laser assembly according to claim 1, **characterized in that** the first and second optical devices (8, 9) are each formed by at least one plate spreader (8.1, 9) comprising a plurality of plates (10, 11) adjoining to one another on their surface sides, **in that** the plates (10) of the first optical device (8) are oriented with their surface sides perpendicular to the first axis (Y axis) and the plates (11) of the second optical device (9) are oriented with their surface sides perpendicular to the third axis (Z axis).

3. Laser assembly according to claim 1 or 2, **characterized in that** at least two parallel diode laser stacks (5) are provided offset to one another in the direction of the first axis (Y axis), and the laser bars (6) of one diode laser stack are oriented with their active layers parallel to the active layers of the laser bars (6) of the other stack.

4. Laser assembly according to one of the preceding claims, **characterized in that** the converter (2) has a converter fiber (14), around which a cooling medium flows, and which consists of at least an inner fiber (15), doped with a laser-active additive and made from light conducting material, preferably made from glass or quartz glass, and a non-doped pump cladding (16) made from a light conducting material, preferably made from glass or quartz glass, surrounding this inner fiber (15).

5. Laser assembly according to one of the preceding claims, **characterized in that**, an optical element (22, 23) functioning as a resonator mirror is provided at the ends of the converter fiber (14) or opposite these ends, and that the one optical element (22), arranged in the beam path between the pump source (3) and the converter fiber (14) and flowed through by the pump radiation of the pump source, functions as an anti-reflection mirror for the laser or pump radiation coupled into the converter fiber (14) from the pump source and functions as a mirror with high reflection for the radiation coming from the converter fiber (14).

6. Laser assembly according to claim 5, **characterized in that**, during decoupling of the converted radiation at the second optical element (23) functioning as a resonator mirror, this element functions as a mirror of high reflection for the pump radiation and as an anti-reflection mirror for the converted radiation coupled out from the converter fiber (14).

7. Laser assembly according to claim 5 or 6, **characterized in that** the optical elements are each concave-convex resonator mirrors (22, 23), which are respectively concave in a concave mirror-like way on the side facing the ends of the converter fiber (14) and are respectively convex in a convergent lens-like way on the side facing away from the converter fiber (14).

8. Laser assembly according to one of claims 5 - 7, **characterized in that** the optical elements (22, 23) consist of a light-permeable material, preferably glass or quartz glass, and that the reflection properties are achieved through material properties and/or a surface coating.

9. Laser assembly according to one of the preceding claims, **characterized in that** the wavelength of the pump radiation lies in the range between 900 nm and 1050 nm and/or the wavelength of the converted radiation lies in the range from 1050 nm and 1100 nm.

10. Laser assembly according to one of the preceding claims, **characterized in that** the sheath (21) consists of two tube and/or hose pieces (29) connected to one another via at least one holding element (24) for the converter fiber (14).

11. Laser assembly according to one of the preceding claims, **characterized in that** the inner, active fiber has a diameter in the range between 10 µm and 200 µm and/or the pump cladding (16) has a diameter in the range between 400 µm and 2000 µm.

12. Laser assembly according to one of claims 1 - 5, **characterized in that** a mirror (30), which separates the radiation from the pump source to the converter from a radiation in the reverse direction, is arranged in the beam path of the pump beam when coupling out the converted laser beam at the side of the converter (2) facing the pump source (3).

## Revendications

1. Ensemble laser comportant un convertisseur (2) réalisé comme laser à fibre pour obtenir un rayonnement de sortie laser converti ainsi que d'une source de pompage (3) fournissant un rayonnement de pompage pour le convertisseur (2) avec plusieurs diodes laser produisant le rayonnement de pompage, lesquelles sont respectivement formées d'émetteurs sur des barrettes laser (6), dans lequel la source de pompage (3) comporte une optique de modelage de rayon (13) permettant de former le rayonnement de pompage à partir des rayons laser (7) fournis par les émetteurs, au moins deux barrettes laser (6), dont les émetteurs sont disposés de manière consécutive dans une première direction d'axe (axe Y) correspondant à un axe lent et lesquels sont agencés respectivement avec leurs couches actives dans un plan (plan XY), lequel inclut le premier axe (axe Y) ainsi qu'un deuxième axe perpendiculaire à celui-ci (axe X), sont agencées l'une au-dessus de l'autre dans la source de pompage (3) en au moins un empilement de diodes laser (5) dans un troisième axe (axe Z) correspondant à un axe rapide, lequel est orienté perpendiculairement au premier et au deuxième axe, et l'optique de modelage de rayon (13) comporte dans le chemin optique, à la suite de l'empilement de diodes laser (5), un premier dispositif optique permettant l'étalement dans le troisième axe des rayons laser (7) fournis par les émetteurs de chaque barrette laser (6) ainsi qu'un deuxième dispositif optique (9) se raccordant au premier dispositif optique, avec lequel les rayons laser étalés (7.1) de toutes les barrettes laser (6) sont assemblés par superposition dans la direction du premier axe (axe Y) en un faisceau de rayons laser (7.2), dans lequel le convertisseur (2) comprend une fibre de conversion multicouches (14) comportant une fibre active interne (15) faite d'un matériau conduisant la lumière et dopé avec un milieu laser actif ou substance laser active, laquelle est logée dans l'espace intérieur (21.3) d'une enveloppe (21) s'étendant sur toute la longueur de la fibre, tubulaire ou de type tuyau et pouvant être parcourue par un milieu de refroidissement liquide, dans lequel la fibre de conversion (14) est prévue respectivement à ses deux extrémités avec un raccord sous forme d'un capuchon (19, 20) constitué d'un matériau conduisant la lumière pour le couplage et/ou le découplage du rayonnement de pompage et du rayonnement converti, les raccords pénétrant respectivement avec une longueur partielle dans l'espace intérieur (21.3) de l'enveloppe (21) pour leur refroidissement et étant bonifiés avec une couche antiréfléchissante pour le rayonnement de pompage et le rayonnement converti et étant reliés à la fibre active (15) au moyen d'un joint épissé.

2. Ensemble laser selon la revendication 1, **caractérisé en ce que** le premier et le deuxième dispositif optique (8, 9) sont respectivement formés d'au moins un éventail de plaques (8.1, 9) avec plusieurs plaques (10, 11) adjacentes sur leurs côtés de surface, **en ce que** les plaques (10) du premier dispositif optique (8) sont orientées perpendiculairement au premier axe (axe Y) avec leurs côtés de surface et les plaques (11) du deuxième dispositif optique (9) sont orientées perpendiculairement au troisième axe (axe Z) avec leurs côtés de surface.

3. Ensemble laser selon la revendication 1 ou 2, **caractérisé en ce qu'**au moins deux empilements de diodes laser (5) parallèles et décalés l'un par rapport à l'autre dans la direction du premier axe (axe Y) sont prévus, **en ce que** les barrettes laser (6) d'un empilement de diodes laser sont orientées avec leurs couches actives parallèlement aux couches actives des barrettes laser (6) de l'autre empilement.

4. Ensemble laser selon l'une des revendications précédentes, **caractérisé en ce que** le convertisseur (2) comporte une fibre de conversion (14) entourée par un milieu de refroidissement, laquelle est constituée d'au moins une fibre interne (15), dopée avec un additif laser actif, en matériau conduisant la lumière, de préférence en verre ou en verre de quartz, ainsi que d'une gaine de pompage (16) non-dopée entourant cette fibre interne (15), en matériau conduisant la lumière, de préférence en verre ou en verre de quartz.

5. Ensemble laser selon l'une des revendications précédentes, **caractérisé en ce qu'**un élément optique (22, 23) fonctionnant comme miroir résonateur est respectivement disposé aux extrémités de la fibre de conversion (14) ou en face de ces extrémités et **en ce que** l'un élément optique (22) agencé dans le chemin optique entre la source de pompage (3) et la fibre de conversion (14) et parcouru par le rayonnement de pompage de la source de pompage opère pour le rayonnement laser ou de pompage couplé dans la fibre de conversion (14) à partir de la source de pompage comme miroir antiréfléchissant et pour le rayonnement venant de la fibre de conversion (14) comme miroir hautement réfléchissant.

6. Ensemble laser selon la revendication 5, **caractérisé en ce que** lors du découplage du rayonnement converti au deuxième élément optique (23) fonctionnant comme miroir résonateur, cet élément opère comme miroir hautement réfléchissant pour le rayonnement de pompage et comme miroir antiréfléchissant pour le rayonnement converti découplé de la fibre de conversion (14).

7. Ensemble laser selon la revendication 5 ou 6, **caractérisé en ce que** les éléments optiques sont respectivement des miroirs résonateurs concave-convexe (22, 23), lesquels sont respectivement concaves en forme de miroir concave à leur côté faisant face aux extrémités de la fibre de conversion (14) et bombés convexes en forme de lentille convexe à leur côté se détournant de la fibre de conversion (14).

8. Ensemble laser selon l'une des revendications 5-7, **caractérisé en ce que** les éléments optiques (22, 23) sont constitués d'un matériau transparent, de préférence en verre ou en verre de quartz, et **en ce que** les propriétés de réflexion sont obtenues par les propriétés de matériau et/ou par un revêtement de surface.

9. Ensemble laser selon l'une des revendications précédentes, **caractérisé en ce que** la longueur d'onde du rayonnement de pompage se trouve dans un intervalle entre 900 nm et 1050 nm et/ou la longueur d'onde du rayonnement converti se trouve dans un intervalle entre 1050 nm et 1100 nm.

10. Ensemble laser selon l'une des revendications précédentes, **caractérisé en ce que** l'enveloppe (21) est constituée de deux pièces de tube et/ou de tuyau (29) reliées l'une à l'autre par le biais d'au moins un élément de maintien (24) pour la fibre de conversion (14).

11. Ensemble laser selon l'une des revendications précédentes, **caractérisé en ce que** la fibre active interne présente un diamètre dans un intervalle entre 10 µm et 200 µm et/ou la gaine de pompage (16) présente un diamètre dans un intervalle entre 400 µm et 2000 µm.

12. Ensemble laser selon l'une des revendications 1-5, **caractérisé en ce que** lors d'un découplage du rayon laser converti un miroir (30) est agencé dans le chemin optique du rayonnement de pompage sur le côté du convertisseur (2) tourné vers la source de pompage (3), ce miroir séparant le rayonnement de la source de pompage au convertisseur d'un rayonnement dans le sens inverse.
